(19) Europäisches Patentamt

European Patent Office

Office européen des brevets

(11) **EP 1 293 798 B1**

(12) **EUROPÄISCHE PATENTSCHRIFT**

(45) Veröffentlichungstag und Bekanntmachung des Hinweises auf die Patenterteilung:
**05.04.2006 Patentblatt 2006/14**

(51) Int Cl.:
*G01S 7/40* (2006.01)    *H03G 3/30* (2006.01)

(21) Anmeldenummer: **02013346.8**

(22) Anmeldetag: **19.06.2002**

(54) **Sende/Empfangs-Modul einer aktiven phasengesteuerten Radarantenne**

Transmit/Receive module of an active phased array Radar antenna

Module Emission/Reception d'une antenne radar à réseau de déphasage actif

(84) Benannte Vertragsstaaten:
**DE FR GB IT NL**

(30) Priorität: **21.08.2001 DE 10140897**

(43) Veröffentlichungstag der Anmeldung:
**19.03.2003 Patentblatt 2003/12**

(73) Patentinhaber: **EADS Deutschland GmbH**
**85521 Ottobrunn (DE)**

(72) Erfinder:
• **Gantert, Steffen**
**88090 Immenstaad (DE)**
• **Güttich, Ulrich, Dr.**
**89233 Neu-Ulm (DE)**

(74) Vertreter: **Meel, Thomas**
**Patentassessor,**
**c/o Dornier GmbH**
**L H G**
**88039 Friedrichshafen (DE)**

(56) Entgegenhaltungen:
**EP-A- 0 803 973      EP-A- 0 907 239**
**EP-B- 0 473 299      US-A- 5 353 031**

**Beschreibung**

Die Erfindung betrifft ein Sende/Empfangs-Modul (in der Literatur auch als T/R-Module bezeichnet) einer aktiven phasengesteuerten Radarantenne mit steuerbarer Ausgangsleistung.

Herkömmliche, mechanisch schwenkbare Antennen werden immer mehr durch aktive, phasengesteuerte Antennen (active phased array antenna) abgelöst, da nur diese die Anforderungen moderner Radarsysteme bezüglich hoher Schwenkgeschwindigkeit des Strahlungsdiagramms der Antenne erfüllen. Die Antenne ist aus einem Array von vielen Einzelstrahlern aufgebaut, denen jeweils ein komplettes Sende/Empfangs-Modul zugeordnet ist.

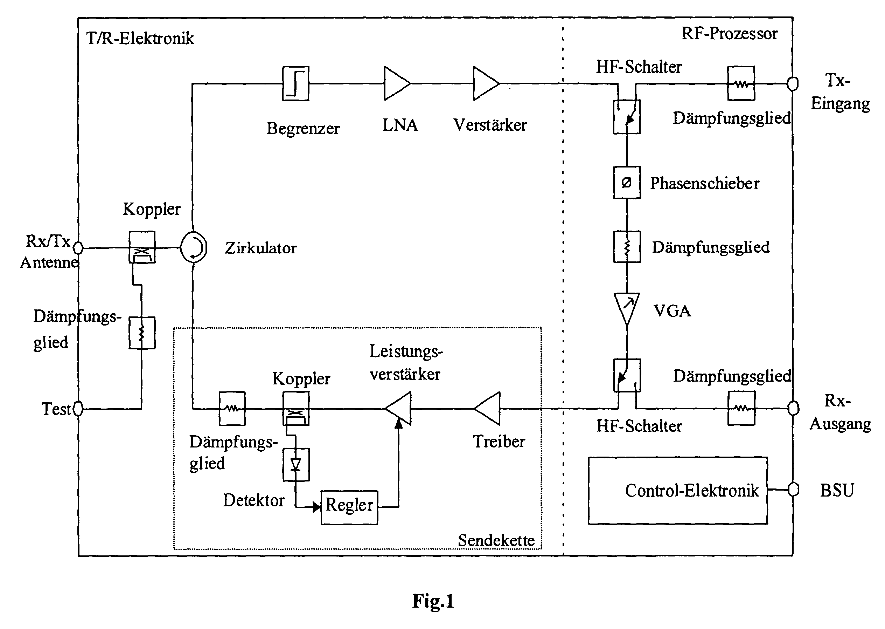

Fig. 1 zeigt zum besseren Verständnis ein Sende/Empfang-Modul gemäß dem Stand der Technik (European Conference on Synthetic Aperture Radar 1998: Next Generation SAR, Antennas and T/R-Modules, 1998, S. 221 ff), von dem die Erfindung ausgeht.

Der Phasenschieber und der VGA (Variable Gain Amplifier) werden von der BSU (Beam Steering Unit) über die Control-Elektronik mit einer Auflösung von 6Bit im Sende- und Empfangsbetrieb digital gesteuert. Mit der BSU werden die Amplituden- und Phasenbelegungen für jedes der in der Antenne vorhandenen Sende/Empfangsmodule eingestellt.

Im Sendebetrieb wird der HF-Puls vom Tx-Eingang über die HF-Schalter, die von der BSU über die Control-Elektronik des Moduls gesteuert werden, über den Phasenschieber und den VGA zur Sendekette geleitet. Dabei wird die Phase des Pulses je nach gewünschter Abstrahlrichtung eingestellt und die Verstärkung des VGA bleibt konstant. Der Vorverstärker (Treiber) und der Leistungsverstärker (HPA - High Power Amplifier) verstärken den HF-Sendepuls auf die erforderliche nominale Ausgangsleistung des Sende/Empfangs-Moduls ($P_{out}$=35dBm) und geben diesen über den Zirkulator und den Tx-Ausgang an die Antenne ab. Der Treiberverstärker und der Leistungsverstärker arbeiten dabei in Leistungskompression, um einen maximalen Wirkungsgrad zu erzielen.

Die in der Sendekette vorhandene Power-Control-Loop aus Koppler, Detektor und Regler soll die Ausgangsleistung des HPA bei Schwankungen der Eingangsleistung und der Temperatur konstant halten. Zu diesem Zweck wird mittels des Kopplers (Richtkoppler mit einer Koppeldämpfung $a_K$=17dB) ein Teil der Ausgangsleistung ausgekoppelt, der von der nachfolgenden Detektorschaltung in eine Gleichspannung gewandelt wird. Diese Gleichspannung ist eine über eine Vielzahl von HF-Pulsen gemittelte Größe und stellt das Maß für die Größe der Ausgangsleistung des Verstärkers dar. Der nachgeschaltete P-Regler steuert die Gatespannung des Leistungsverstärkers in Abhängigkeit der Ausgangsspannung der Detektorschaltung. Dadurch soll gewährleistet werden, dass der Leistungsverstärker immer in der Sättigung betrieben wird, wodurch der Verstärker stets eine konstante Ausgangsleistung abgibt.

Die Sendekette ist auf Grund der Energieeinsparung nur während der Zeitdauer des HF-Pulses in Betrieb.

Im Empfangsbetrieb wird das Radarecho von dem Empfangselement der Antenne über den Rx-Eingang und den Zirkulator auf den Empfangszweig geleitet, der das schwache Eingangssignal mit minimalem Rauschen verstärkt. Zu diesem Zweck ist der erste Verstärker ein LNA (low noise amplifier) mit geringer Rauschzahl, der durch den nichtreflektierenden Begrenzer vor zu großen Eingangsleistungen geschützt wird. Die HF-Schalter werden von der BSU so gesteuert, dass das verstärkte Empfangssignal nach entsprechender Phasen- und Amplitudenbelegung zum Rx-Ausgang geleitet wird.

Im Zusammenhang mit dem beschriebenen Sende/Empfangs-Modul sind die folgenden Nachteile zu nennen:

Für eine optimale Nebenzipfelunterdrückung ist sowohl in der Elevationsebene als auch in der Azimutebene der Antenne eine kontinuierliche, nichtlineare Leistungsbelegung der einzelnen Strahlerelemente notwendig. Sende/Empfangs-Module der heutigen Technologie sind bezüglich der Ausgangsleistung des Sendesignals jedoch nicht elektronisch einstellbar. Dies führt zu dem Kompromiss, dass die Sende/Empfangs-Module in diskrete Leistungsklassen für eine Annäherung an die optimale Leistungsbelegung der Antenne eingeteilt werden. In dem in Fig. 1 dargestellten Sende/Empfangs-Modul wird dies durch die Einführung eines dem Leistungsverstärker nachgeschalteten Dämpfungsglied realisiert, das die Ausgangsleistung des Moduls vermindert. Je nach Leistungsklasse wird die Dämpfung unterschiedlich groß gewählt. Bei Modulen der höchsten Leistungsklasse ist a=0dB und somit nicht vorhanden.

Die beschriebene Power-Control-Loop des Sende/Empfangs-Moduls gemäß Fig. 1 hält die Ausgangsleistung des Leistungsverstärkers konstant und gleicht damit Änderungen der Ausgangsleistung auf Grund von Schwankungen der Temperatur und der Eingangsleistung des HPA aus, wobei bei hoher Ausgangsleistung ein guter Wirkungsgrad erzielt wird. Eine Optimierung des Wirkungsgrades und vor allem der Leistungsaufnahme gerade bei kleinen Ausgangsleistungen ist bei Anwendungen mit begrenzter Stromversorgungskapazität wie zum Beispiel auf Satelliten aber unabdingbar, denn die Leistungsaufnahme eines einzelnen Sende/Empfangs-Moduls summiert sich bei der Menge der benötigten Module (typische Anzahl von Sende/Empfangs-Modulen für eine Antenne auf einer fliegenden Plattform: ca. 1000) schnell zu Größenordnungen auf, bei denen jede unnötig verbrauchte Energie mit höherem technischen Aufwand im Servicemodul des Satelliten teuer bezahlt werden muss.

In der **EP-B-0 473 299** ist ein Verfahren zur Steuerung der Ausgangsleistung eines Leistungsverstärkers beschrieben, mit der die beschriebenen Nachteile ausgeräumt werden können. Dabei wird die Eingangsleistung entsprechend der zu erzielenden Ausgangsleistung eingestellt, wobei der Gewinn durch eine Regelung konstant gehalten wird. Regelgröße für die Konstanthaltung des Gewinns ist die Betriebsspannung des Leistungsverstärkers.

Aufgabe der vorliegenden Erfindung ist es, einen Regelkreis zur Steuerung der Ausgangsleistung des Sende/Empfangs-Moduls zu schaffen, mit der eine stabile und von äußeren Einflüssen unabhängige Regelung ermöglicht wird.

Diese Aufgabe wird mit dem Gegenstand gemäß Patentanspruch 1 gelöst. Vorteilhafte Ausführungen sind Gegenstand weiterer Ansprüche.

Gemäß der Erfindung wird eine Steuerung der Ausgangsleistung des Sende/Empfangsmoduls durch gezielte Einstellung der Eingangsleistung der Sendekette erreicht, wobei der Gewinn der in der Sendekette vorhandenen Verstärker zur Verstärkung des HF-Sendesignals stets durch eine Regelung konstant gehalten wird. Bei konstanten Gewinn der Verstärker ist die Ausgangsleistung bekannt, wenn die Eingangsleistung mit dem VGA des Sende/Empfangs-Moduls eingestellt wird.

Dabei kann gleichzeitig sichergestellt werden, dass die eingestellte Ausgangsleistung trotz vorhandener Störeinflüsse wie z.B. Temperaturänderungen, konstant auf gleichem Niveau gehalten wird.

Die Regelung des Gewinns der Verstärker kann so schnell erfolgen, dass eine Abweichung der Ausgangsleistung vom Sollwert innerhalb einer Zeitdauer $t=5\mu s$ ausgeglichen werden kann. Die Regelung kann deshalb insbesondere als Intrapulsregelung ausgeführt werden, d.h. wenn im Radarbetrieb die Verstärker gepulst betrieben werden (z.B. $t_{puls,max}=50\mu s$), kann die Amplitudenabweichung innerhalb des HF-Pulses ausgeregelt werden.

Die Steuerung der Ausgangsleistung ist über einen weiten Dynamikbereich (D = 18dB) bis zu einer maximalen, stabilisierten Ausgangsleistung von $P_{out}$ = 35 dBm möglich.

Mit der erfindungsgemäßen Regelung kann unter Berücksichtigung eines optimalen Wirkungsgrades und minimalen Leistungsverbrauchs die Ausgangsleistung des Moduls konstant gehalten werden. Sie lässt außerdem die Steuerung dieser Ausgangsleistung unter Einhaltung vorgegebener Anforderungen zu. Der unnötige Verbrauch von erzeugter Ausgangsleistung mittels eines Dämpfungsgliedes wie bei dem T/R-Modul gemäß Fig. 1 sowie eine zu hohe Leistungsaufnahme der Verstärker der Sendekette kann vermieden werden.

Durch Einsatz der erfindungsgemäßen Sende/Empfangs-Module in einer aktiven, phasengesteuerten Radarantenne kann durch eine elektronisch eingestellte, funktionale Leistungsbelegung der Antennenapertur die Leistung der Nebenzipfel drastisch gesenkt werden. Weiterhin wird der Leistungsverbrauch der gesamten Antenne und damit verbunden die Infrarotabstrahlung stark verringert. Die geringere Leistung der Nebenzipfel sowie die geringere Infrarotabstrahlung führen zu einer kleineren Entdeckungswahrscheinlichkeit des Radars. Der geringere Leistungsverbrauch entlastet außerdem die Anforderungen an die Energieversorgung auf autonomen Plattformen (z.B. Satelliten).

Die Erfindung wird anhand von Ausführungsbeispielen unter Bezugnahme auf Figuren näher erläutert. Es zeigen:

Fig. 1 ein Sende/Empfangsmodul gemäß Stand der Technik, wie in der Beschreibungseinleitung erläutert;

Fig. 2 den Sendezweig eines Sende/Empfangsmoduls gemäß der Erfindung;

Fig. 3 der Regelkreis zur Konstanthaltung des Gewinns des Leistungsverstärkers gemäß der Erfindung;

Fig. 4 der Wirkungsgrad eines Verstärkers der Sendekette in Abhängigkeit von der Ausgangsleistung $P_{out}$ und der Drain-Source-Spannung $U_{DS}$;

Fig. 5 die Leistungsaufnahme des Verstärkers nach Fig. 4 in Abhängigkeit von der Eingangsleistung $P_{in}$ und des Gewinns G des Verstärkers.

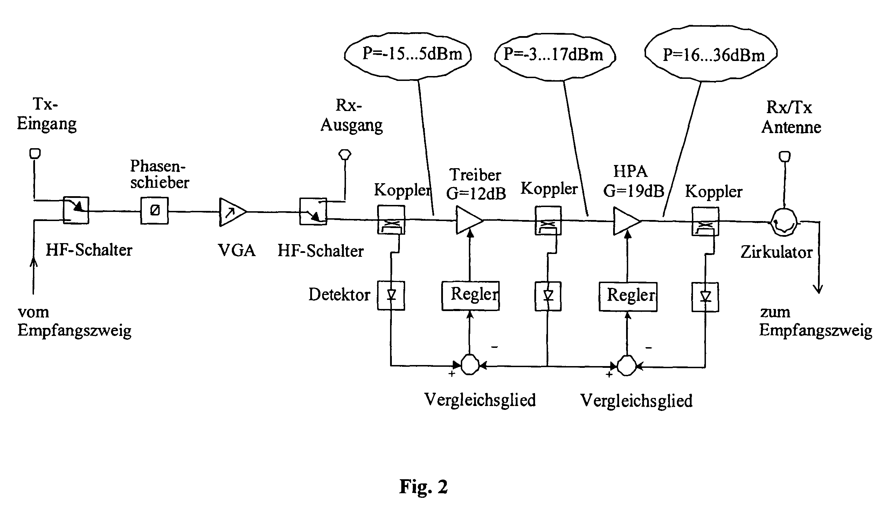

Fig. 2 zeigt den gegenüber dem bekannten Sende/Empfangs-Modul gemäß Fig. 1 modifizierten erfindungsgemäßen Aufbau für den Sendezweig eines Sende/Empfangs-Moduls. Soweit einzelne Komponenten unverändert übernommen wurden, wird zur Vermeidung von Wiederholungen auf die Beschreibung von Fig. 1 verwiesen.

Der gezeigte Schaltungsaufbau ermöglicht die Steuerung der Ausgangsleistung des Sende/Empfangs-Moduls, indem die Eingangsleistung der Sendekette am vorgeschalteten VGA gezielt eingestellt wird. Gleichzeitig wird der Gewinn der beiden in der Sendekette enthaltenen Verstärker (Treiber. -Leistungsverstärker HPA) auf einen konstanten Wert geregelt.

Als Nebenbedingung wird die Leistungskompression der Verstärker konstant gehalten. Dies ist aus zwei Gründen vorteilhaft:

- Konstanthaltung der Schleifenverstärkung der Regelung des Verstärkergewinns;
- Im Hinblick auf eine möglichst geringen Energieverbrauch kann so die minimal erforderliche Drain-Source-Spannung zur Verfügung gestellt werden.

Im Gegensatz zum bekannten Design wird die Eingangsleistung des Treibers vorteilhaft von $P_{in}=7dBm$ auf maximal $P_{in.max}=5dBm$ und die Eingangsleistung des Leistungsverstärkers von $P_{in}=21dBm$ auf maximal $P_{in.max}= 17dBm$ reduziert, um die Auswirkungen von Gleichrichteffekten am HPA zu minimieren und um diesen durch eine zu geringe Verstärkung nicht unnötigerweise abzuschnüren, wodurch größere Verzerrungen des Ausgangssignals hervorgerufen werden. Weiterhin ist es im Hinblick auf geringe Leistungsaufnahme nicht sinnvoll, zu hohe Eingangsleistungen zur Verfügung zu stellen, die nicht benötigt werden und durch die bereits genannten Gleichrichteffekte höhere Drainströme zur Folge haben, die wiederum den Wirkungsgrad senken.

Die Einstellung der Eingangsleistung des Treiberverstärkers z.B. im Bereich -15dB≤$P_{in}$≤5dBm wird mit dem der Sendekette vorgeschalteten VGA vorgenommen. In der Sendekette wird das HF-Signal am Eingang und Ausgang des Treiberverstärkers und am Eingang und Ausgang des Leistungsverstärkers HPA ausgekoppelt und die Leistung des HF-Signals mit entsprechend schnellen Detektoren gemessen. Der Vergleich von Eingangs- und Ausgangsleistung an einem Vergleichsglied liefert jeweils die Informationen, die ein Regler zur Regelung des Gewinns der Verstärker benötigt. Die Verstärkung wird mit Hilfe der Gatespannung des jeweiligen Verstärkers geregelt, wobei die Drain-Source-Spannung je nach eingestellter Eingangsleistung vorgegeben werden muss. Dabei kann in einer besonders vorteilhaften Ausführung die nominelle Verstärkung des Treibers (CHA5010a, Hersteller: UMS) G=12dB (Variation im Bereich 11,2dB≤G≤14dB) und die des HPA (TGA9083, Hersteller: Triquint) G=19dB (Variation im Bereich 18,4dB≤G≤20dB) betragen.

Die Arbeitspunkte der Verstärker werden durch die Gate- und Drain-Source-Spannung bestimmt. Für eine gewünschte Ausgangsleistung wird demnach nach gewähltem Gewinn der Verstärker die erforderliche Eingangsleistung bereitgestellt, für die wiederum die zugehörigen Drain-Source-Spannung eingestellt werden muss, um die Kompression über alle Eingangsleistungen konstant zu halten. Die für den gewählten Gewinn der Verstärker notwendige Gatespannung wird nicht vorgegeben, sondern stellt sich im Regelkreis automatisch ein, sobald sich dieser im Gleichgewicht befindet. Die Gatespannung des Treiberverstärkers beträgt demnach bei dem nominellen Gewinn (G=12dB) $U_{gs}$= -2,35V und die des HPA beträgt bei dem nominellen Gewinn (G=19dB) $U_{gs}$=-0,92V. Mit diesen Einstellungen kann die Ausgangsleistung des HPA im Bereich 16dB≤$P_{out}$≤36dBm variiert werden. Hierbei wurden die im vorhergehenden Absatz angegebenen Verstärkermodelle eingesetzt.

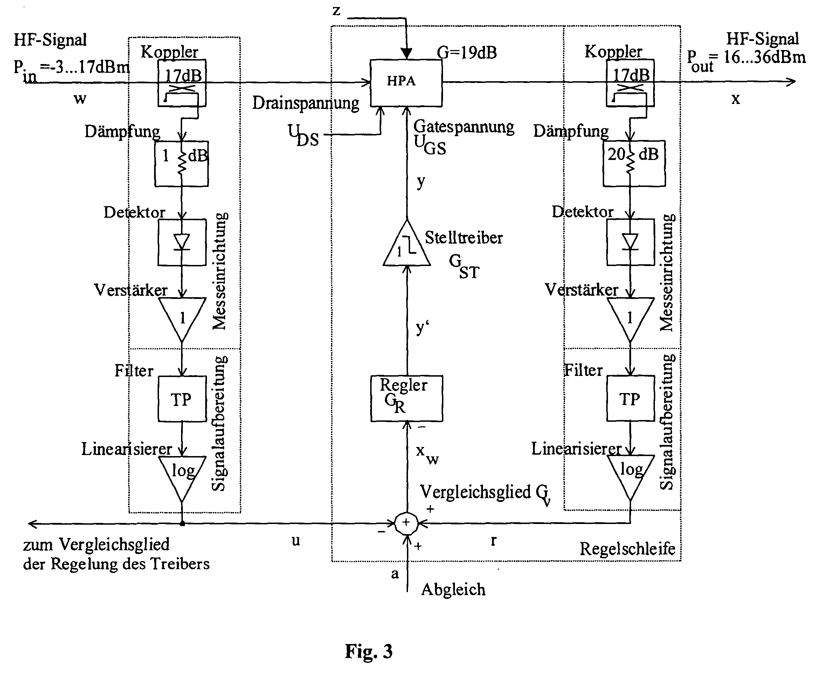

Fig. 3 beschreibt den Regelkreis des Leistungsverstärkers HPA im Detail. Der entsprechende Regelkreis des Treiberverstärkers ist im Wesentlichen identisch, und wird deshalb hier nicht dargestellt.

Das HF-Signal wird am Ausgang des HPA mit einer Koppeldämpfung von z.B. $a_K$=17dB mittels eines Kopplers ausgekoppelt und mit einer zusätzlichen Dämpfung a=20dB einem Detektor zugeführt, der damit das HF-Signal mit einem Leistungspegel im Bereich $P_{det}$=-21... -1dBm in eine Gleichspannung wandelt. Der nachfolgende Verstärker ist ein Impedanzwandler, der den hochohmigen Ausgang der Detektorschaltung vom nachfolgenden Schleifenfilter TP entkoppelt. Das Schleifenfilter prägt der Regelschleife ein definiertes dynamisches Verhalten auf und stabilisiert die Regelung. Diese vier Glieder bilden die Messeinrichtung. Das Schleifenfilter stellt einen Tiefpass dar, der den Kreisfrequenzgang der dargestellten Regelschleife aus Stabilitätsgründen bei hohen Frequenzen begrenzen soll.

Der nachfolgende Linearisierer stellt eine Proportionalität zwischen der logarithmischen Ausgangsleistung $P_{out.dBm}$ des HPA und der Ausgangsspannung des Detektors her, wodurch eine konstante Regelabweichung $X_w$ bei gleicher Abweichung der Verstärkung über alle Eingangsleistungen sowie eine konstante Schleifenverstärkung über verschiedene Gatespannungen gewährleistet werden soll.

Die Führungsgröße w der Regelung ist die Leistung des HF-Eingangssignals des HPA, aus der die Vergleichsgröße u gebildet wird. Dies geschieht mit dem gleichen Aufbau der Messeinrichtung und der Signalaufbereitung wie in der beschriebenen Regelschleife mit dem Unterschied der um Δa= 19dB verringerten Dämpfung nach dem Koppler. Dies gewährleistet denselben Leistungspegel $P_{det}$=-21...-1dBm an der Detektorschaltung wie in der Messeinrichtung für die Ausgangsleistung des HPA, wodurch sich die Glieder beider Zweige stets im gleichen Arbeitspunkt befinden und das gleiche Übertragungsverhalten aufweisen. Weiterhin werden dadurch Temperatureinflüsse, die sich in beiden Zweigen gleichermaßen auswirken, bei der Bildung der Regelabweichung $X_w$ kompensiert. Die sonstigen möglichen Störeinflüsse (Temperatur, Drain-Source-Spannungsschwankung) sind in der Störgröße z zusammengefasst. Die Regelabweichung $X_w$ ergibt sich nach Subtraktion der Vergleichsgröße u von der Rückführgröße r im Vergleichsglied $G_v$.

Auf Grund der Differenz der Einfügedämpfung Δa=19dB in beiden Zweigen wird die Regelabweichung $X_w$=0, wenn die Differenz zwischen Eingangs- und Ausgangsleistung des HPA exakt ΔP= 19dB beträgt, wodurch eine Verstärkung G=19dB erzwungen wird.

Durch den Eingriff der Abgleichgröße a kann eine zusätzliche Regelabweichung generiert werden, die eine Störung des Gleichgewichtes zwischen Eingangs- und Ausgangsleistung vortäuscht und eine Änderung der Verstärkung zur Folge hat. Mit der Abgleichgröße a kann somit ein Feinabgleich des Gewinns des Verstärkers vorgenommen werden.

Der Regler $G_R$, der die Stellgröße y (Gatespannung $U_G$) steuert, schließt den Regelkreis. Hier wird ein PI-Regler eingesetzt, der die Regelabweichung stets gegen Null minimiert. Der Stelltreiber $G_{ST}$ dient der Entkopplung des Reglers $G_R$ vom Stellglied und soll zusätzlich die Gatespannung $U_G$ auf zulässige Werte begrenzen, um den HPA vor Zerstörung zu schützen.

Ein Maß für den effizienten Einsatz eines Verstärkers ist der Wirkungsgrad, der gemäß

$$PAE = \frac{P_{out} - P_{in}}{P_{dc}} * \tau$$

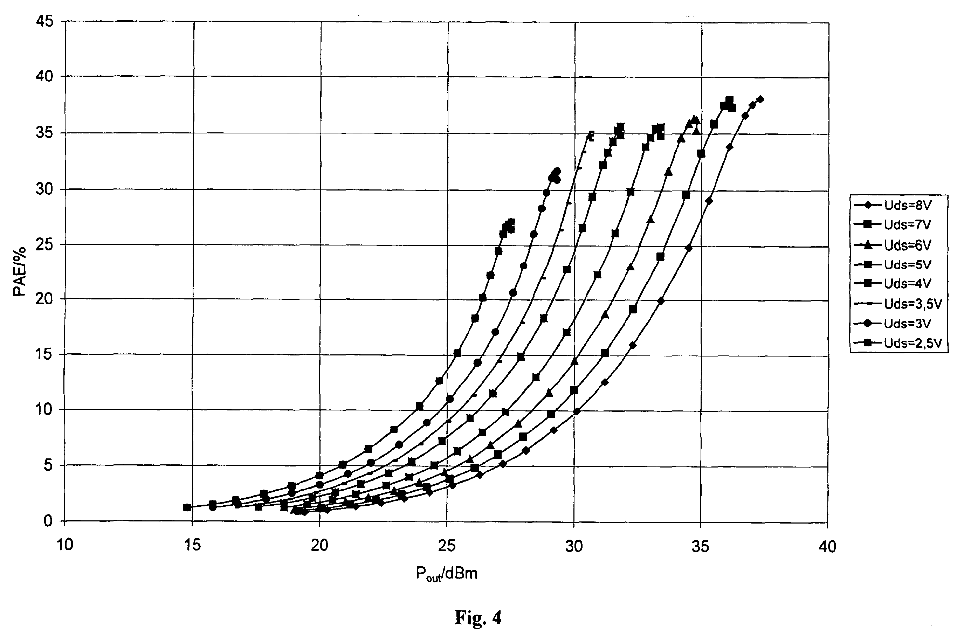

definiert ist (die darin verwendeten Größen sind unten erläutert). Fig. 4 zeigt den Wirkungsgrad des Verstärkers TGA9083 in Abhängigkeit von der Ausgangsleistung $P_{out}$ und der Drain-Source-Spannung $U_{DS}$. Die Ausgangsleistung $P_{out}$ wurde dabei mit der Eingangsleistung $P_{in}$ des Verstärkers variiert. Dabei wird deutlich, dass der Wirkungsgrad bei kleinen Eingangs- und Ausgangsleistungen sehr klein ist und bei höchster Ausgangsleistung maximal wird. Der exponentielle Anstieg des Wirkungsgrades über der logarithmisch dargestellten Ausgangsleistung in Fig. 4 geht aus obiger Formel hervor, in der Eingangs- und Ausgangsleistung exponentiell ansteigen, wobei die aufgenommene Leistung $P_{dc}$ bei vorgegebener Drain-Source-Spannung $U_{DS}$ nahezu konstant bleibt.

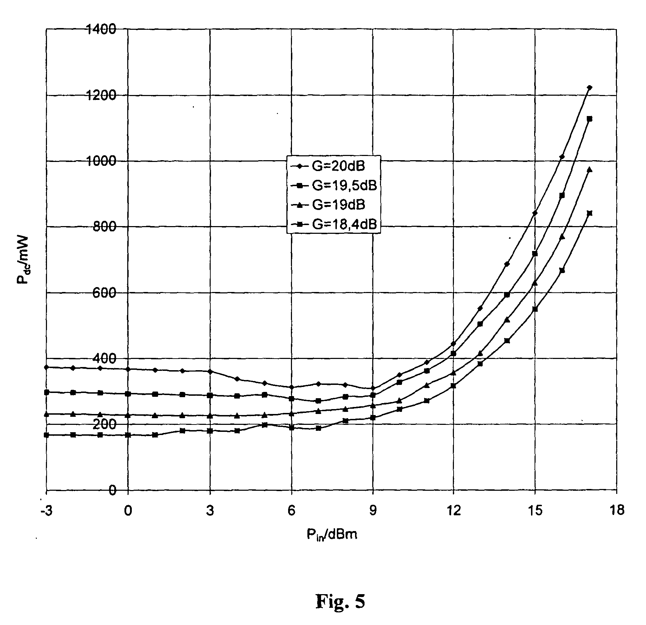

Die Erfindung sieht die Steuerung der Ausgangsleistung des Verstärkers mit dessen Eingangsleistung vor, wobei der Gewinn des Verstärkers mit einer Regelung konstant gehalten werden soll. Dazu ist es notwendig, auch die Kompression des Verstärkers mit Erhöhung der Drain-Source-Spannung $U_{DS}$ konstant zu halten, sobald mit Erhöhung der Eingangsleistung Kompression auftritt. Fig. 5 zeigt die Leistungsaufnahme

$$P_{dc} = U_{DS} * I_D$$

des Verstärkers TGA9083 in Abhängigkeit von der Eingangsleistung $P_{in}$ und des Gewinns G des Verstärkers. Sobald mit Erhöhung der Eingangsleistung Kompression auftritt (etwa bei $P_{in}$=8dBm), wird die Drain-Source-Spannung $U_{DS}$ linear in Abhängigkeit von der Eingangsleistung für konstante Kompression erhöht, wobei die Leistungsaufnahme linear ansteigt. Der exponentielle Anstieg der Kurven in Fig. 5 ist auf die logarithmische Darstellung der Eingangsleistung zurückzuführen.

Aus beiden Diagrammen wird deutlich, dass nicht die Maximierung des Wirkungsgrades, sondern die Minimierung der aufgenommenen Leistung für einen effizienten Betrieb des Verstärkers entscheidend ist. Die Betrachtung des Wirkungsgrades allein ist nicht ausreichend. Eine Optimierung der Leistungsaufnahme kann demnach nur durch eine optimale Einstellung von Eingangsleistung und Drain-Source-Spannung bei vorgegebener Verstärkung erfolgen.

In Fig. 4 und 5 verwendete Größen:

$P_{dc}$: aufgenommene Leistung des Verstärkers
$U_{DS}$: Drain-Source-Spannung, entspricht der Betriebsspannung des Verstärkers
$I_D$ : Drainstrom, entspricht dem Stromverbrauch des Verstärkers

PAE : Power Added Efficiency, Wirkungsgrad
$P_{in}$ : Eingangsleistung des Verstärkers
$P_{out}$: Ausgangsleistung des Verstärkers
$\tau$ : Tastverhältnis, Verhältnis von Pulsdauer zur Periode (Pulsdauer $t_{on}$ + Pulspause $t_{off}$) des gepulsten Radarsignals.

**Patentansprüche**

1. Sende/Empfangs-Modul einer aktiven phasengesteuerten Radarantenne, umfassend

   • einen Verstärker mit variabler Verstärkung;
   • einen dem Verstärker mit variabler Verstärkung nachgeschaltete Sendekette, welche mindestens einen Verstärker zur Verstärkung des HF-Sendesignals umfasst, wobei die Eingangsleistung der Sendekette entsprechend der zu erzielenden Ausgangsleistung des Sende/Empfangs-Moduls eingestellt werden kann und der Gewinn des oder der in der Sendekette enthaltenen Verstärker zur Verstärkung des HF-Sendesignals mittels eines Regelkreises für jeden der in der Sendekette vorhandenen Verstärker konstant gehalten werden kann, wobei ein Regelkreis folgende Komponenten umfasst:
   • einen Koppler zur Auskopplung des Eingangssignals eines Verstärkers in einen erste Regelschleife;
   • einen Detektor zur Messung des Eingangssignals des Verstärkers;
   • einen zweiten Koppler zur Auskopplung des Ausgangssignal des Verstärkers in eine zweite Regelschleife;
   • einen zweiten Detektor zur Messung des Ausgangssignals des Verstärkers;
   • ein Vergleichsglied zum Vergleich von Eingangssignal und Ausgangssignal des Verstärkers;
   • einen Regler, der aus den im Vergleichsglied gewonnenen Informationen die Konstanthaltung des Gewinns des Verstärkers regelt,

   **dadurch gekennzeichnet, dass** der Regelkreis die folgenden weiteren Komponenten enthält:

   • den Detektoren jeweils vorgeschalte Dämpfungsgliede unterschiedlicher Dämpfung;
   • Schleifenfilter zur Aufprägung eines definierten dynamischen Verhaltens der einzelnen Regelschleifen;
   • den Schleifenfiltern jeweils nachgeschaltete Linearisierer zur Herstellung der Proportionalität zwischen der logarithmischen Ausgangsleistung eines Verstärkers und der Ausgangsspannung des Detektors.

**2.** Sende/Empfangs-Modul nach Anspruch 1, **gekennzeichnet durch** folgende weitere Komponenten:

• den Detektoren jeweils nachgeschalteten Entkoppelverstärker zur Entkopplung des hochohmigen Ausgangs des Detektors von dem nachgeschalteten Schleifenfilter;
• ein dem Regler nachgeschalteter Stelltreiber zur Entkopplung des Reglers vom Gateeingang eines Verstärkers.

**3.** Send/Empfangs-Modul nach Anspruch 1 oder 2, **dadurch gekennzeichnet, dass** die Stellgröße des Regelkreises die Gatespannung eines Verstärkers ist.

**4.** Sende/Empfangs-Modul nach einem der Ansprüche 1 bis 3, **dadurch gekennzeichnet, dass** der Verstärker innerhalb der Sendekette ein Leistungsverstärker oder ein Treiberverstärker ist.

**Claims**

**1.** Transmission/reception module for an active phased array radar antenna, comprising

• a variable gain amplifier;
• a transmission chain which is connected downstream from the variable gain amplifier and has at least one amplifier for amplification of the RF transmission signal, in which case the input power of the transmission chain can be adjusted such that it corresponds to the output power to be achieved from the transmission/reception module, and the gain of the amplifier or amplifiers which is or are contained in the transmission chain with respect to the amplification of the RF transmission signal can be kept constant by means of a control loop for each of the amplifiers in the transmission chain, with one control loop having the following components:
• a coupler for outputting the input signal to an amplifier to a first control loop;
• a detector for measurement of the input signal to the amplifier;
• a second coupler for outputting the output signal from the amplifier to a second control loop;
• a second detector for measurement of the output signal from the amplifier;
• a comparison element for comparison of the input signal and output signal to and from the amplifier;
• a regulator which uses the information obtained in the comparison element to keep the gain of the amplifier constant,

**characterized in that** the control loop contains the following further components:

• attenuation elements of different attenuation, which are connected upstream of each of the detectors;
• loop filters for application of a defined dynamic response to the individual control loops;
• linearizers, which are connected downstream from each of the loop filters, in order to produce the proportionality between the logarithmic output power of an amplifier and the output voltage of the detector.

**2.** Transmission/reception module according to Claim 1, **characterized by** the following further components:

• decoupling amplifiers, which are connected downstream from each of the detectors, for decoupling the high-impedance output of the detector from the downstream loop filter;
• an actuating driver, which is connected downstream from the regulator, for decoupling the regulator from the gate input of an amplifier.

**3.** Transmission/reception module according to Claim 1 or 2, **characterized in that** the manipulated variable for the control loop is the gate voltage of an amplifier.

**4.** Transmission/reception module according to one of Claims 1 to 3, **characterized in that** the amplifier within the transmission chain is a power amplifier or a driver amplifier.

**Revendications**

**1.** Module d'émission/réception d'une antenne radar active commandée en phase, comprenant

- un amplificateur d'amplification variable ;
- une chaîne d'émission montée en aval de l'amplificateur d'amplification variable, qui comprend au moins un amplificateur pour amplifier le signal d'émission HF (Haute Fréquence), sachant que la puissance d'entrée de la chaîne d'émission peut être réglée en fonction de la puissance de sortie du module d'émission/réception à obtenir, et que le gain du ou des amplificateurs contenus dans la chaîne d'émission pour amplifier le signal d'émission HF peut être, au moyen d'un circuit de régulation, maintenu constant pour chacun des amplificateurs présents dans la chaîne d'émission, un circuit de régulation comprenant les éléments suivants :
- un coupleur pour découpler le signal d'entrée d'un amplificateur dans une première boucle de régulation ;
- un détecteur pour mesurer le signal d'entrée de l'amplificateur ;
- un deuxième coupleur pour découpler le signal de sortie de l'amplificateur dans une deuxième boucle de régulation ;
- un deuxième détecteur pour mesurer le signal de sortie de l'amplificateur ;
- un comparateur pour comparer le signal d'entrée et le signal de sortie de l'amplificateur ;
- un régulateur qui, à partir des informations obtenues dans le comparateur, régule le maintien du gain de l'amplificateur à une valeur constante,

**caractérisé en ce que** le circuit de régulation contient les composants supplémentaires suivants :

- des atténuateurs ayant des atténuations différentes, respectivement montés en amont des détecteurs ;
- des filtres de boucle pour imprimer un comportement dynamique défini aux boucles de régulation individuelles ;
- des linéarisateurs respectivement montés en aval des filtres de boucle, pour réaliser la proportionnalité entre la puissance de sortie logarithmique d'un amplificateur et la tension de sortie du détecteur.

2. Module d'émission/réception selon la revendication 1, **caractérisé par** les composants supplémentaires suivants :

- des amplificateurs de découplage respectivement montés en aval des détecteurs, pour découpler du filtre de boucle monté en aval la sortie à haute impédance du détecteur ;
- un pilote de réglage, monté en aval du régulateur pour découpler le régulateur de l'entrée de grille d'un amplificateur.

3. Module d'émission/réception selon la revendication 1 ou 2, **caractérisé en ce que** la variable réglante du circuit de régulation est la tension de grille d'un amplificateur.

4. Module d'émission/réception selon l'une quelconque des revendications 1 à 3, **caractérisé en ce que** l'amplificateur à l'intérieur de la chaîne d'émission est un amplificateur de puissance ou un amplificateur pilote.

**Fig.1**

T/R-Elektronik

RF-Prozessor

HF-Schalter

Begrenzer  LNA  Verstärker

Dämpfungsglied

Tx-Eingang

Phasenschieber

Koppler

Dämpfungsglied

Rx/Tx Antenne

Zirkulator

VGA

Dämpfungs-glied

Dämpfungsglied

Leistungs-verstärker

Koppler

Rx-Ausgang

Test

Dämpfungs-glied

Treiber

HF-Schalter

Detektor

Regler

Control-Elektronik

BSU

Sendekette

EP 1 293 798 B1

8

Fig. 2

EP 1 293 798 B1

z

HF-Signal
$P_{in} = -3...17dBm$

Koppler
17dB

G=19dB

HPA

Koppler
17dB

HF-Signal
$P_{out} = 16...36dBm$

w

Drainspannung
$U_{DS}$

Gatespannung
$U_{GS}$

x

Dämpfung
1 dB

y

Dämpfung
20 dB

Detektor

Stelltreiber
$G_{ST}$

Detektor

Verstärker
1

y'

Verstärker
1

Messeinrichtung

Messeinrichtung

Filter
TP

Regler
$G_R$

Filter
TP

Signalaufbereitung

$x_w$

Signalaufbereitung

Linearisierer
log

Vergleichsglied $G_V$
+

Linearisierer
log

–

+

u

+

r

Regelschleife

zum Vergleichsglied
der Regelung des Treibers

a

Abgleich

**Fig. 3**

**Fig. 4**

Fig. 5